# EUROPÄISCHE PATENTSCHRIFT

(11) **EP 0 347 569 B1**
(45) Veröffentlichungstag und Bekanntmachung des Hinweises auf die Patenterteilung: **01.02.1995**
(21) Anmeldenummer: 89108349.5
(22) Anmeldetag: 10.05.1989
(51) Int. Cl.: H03L 5/02, H04B 1/04, H03F 1/52, H03G 3/20

(54) **Leistungsregelanordnung**
Power control arrangement
Dispositif de régulation de puissance

(30) Priorität: 23.06.1988 DE 3821181
(43) Veröffentlichungstag der Anmeldung: 27.12.1989
(73) Patentinhaber: Daimler-Benz Aerospace Aktiengesellschaft, 81663 München (DE)
(72) Erfinder: Kombrink, Friedemann, D-7907 Langenau (DE)
(74) Vertreter: Schulze, Harald Rudolf, Dipl.-Ing.

(56) Entgegenhaltungen:
- DE-A- 2 710 752
- DE-A- 3 317 358

## Beschreibung

Die Erfindung betrifft eine Leistungsregelanordnung für Leistungsendstufen frequenzvariabler Sender nach dem Oberbegriff des Patentanspruchs. Eine solche Leistungsregelanordnung ist bereits aus der DE 27 10 752 A1 bekannt.
Zum Schutz von Leistungsendstufen vor Überlastung durch von der Antenne reflektierte Leistung bei schlechter Anpassung ist es üblich, mittels einer Richtkoppleranordnung die auf der Antennenzuleitung vorlaufenden und rücklaufenden Wellen zu überwachen und erforderlichenfalls die Verstärkung der Leistungsendstufe zu reduzieren. Um bei räumlich dicht benachbarten weiteren Sendern, z.B. auf Schiffen, die im gleichen Frequenzbereich mit u.U. nur geringem Frequenzabstand betrieben werden, Störungen der Leistungsregelung mit Vor- und Rücklaufmessung zu vermeiden, sind in die Antennenleitung schmalbandige Sendefilter eingefügt. Da die Sendefrequenz variabel ist, müssen auch diese Filter durchstimmbar sein und automatisch auf die jeweilige Sendefrequenz abgestimmt werden. Diese Sendefilter, über die die gesamte Sendeleistung fließt, sind aber sehr aufwendig und können den Hauptteil der Kosten einer Sendeanlage beanspruchen.

Die in der DE 27 10 752 A1 beschriebene Leistungsregelanordnung kommt ohne solche Sendefilter aus. Stattdessen ist bei dieser bekannten Anordnung ein Meßrichtkoppler am Ausgang der Leistungsendstufe des Senders in die Antennenzuleitung geschaltet. Am ersten Ausgang des Meßrichtkopplers entsteht dabei eine der vorlaufenden Sendeleistung proportionale Wechselspannung, am zweiten Ausgang eine der (bei Fehlanpassung vorhandenen) reflektierten Leistung proportionale Wechselspannung. Diese beiden Wechselspannungen werden nach Gleichrichtung summiert und als Regelgröße zum Einstellen der Ausgangsleistung der Leistungsendstufe des Senders benutzt. Zur Ableitung des Regelsignals wird die summierte Gleichspannung in einem Komparator mit einer der gewünschten Senderausgangsleistung proportionalen Referenzspannung verglichen und bei Abweichung zwischen diesen beiden Spannungen die Leistungseinstellung in der Leistungs-Endstufe entsprechend nachgeregelt. Um hierbei Fehlregelungen durch Einkopplung von externen Störsignalen zu vermeiden, die über die Antenne in den Meßrichtkoppler eingekoppelt werden, ist ferner im Rücklauf-Meßzweig des Meßrichtkopplers eine Frequenzselektionseinrichtung vorgesehen. Diese Einrichtung besteht aus einem Bandpaßfilter, das auf die Sendefrequenz des Senders abgestimmt ist, sowie aus einer Mischstufe, in der das über den Rücklaufzweig des Meßrichtkopplers ausgekoppelte und bandpaßgefilterte Rücklaufsignal mit einem Steuersignal gemischt wird, dessen Frequenz sich um eine konstante Niederfrequenz von der Frequenz des Sendesignals unterscheidet und das im Steuerteil des Senders, also vor der Leistungsendstufe erzeugt wird.

Die Mischerausgangssignale werden anschließend einem auf die Niederfrequenz abgestimmten zweiten Bandpaßfilter zugeführt. Die ausgefilterten niederfrequenten Signalanteile werden anschließend zusammen mit dem Ausgangssignal des Vorlaufszweigs des Richtkopplers zur Ableitung des Regelsignals in der zuvor beschriebenen Weise herangezogen.

Zwar werden mit dieser Frequenzselektionseinrichtung Fehlregelungen vermieden, die durch Störsignaleinkopplungen über den Rücklaufzweig des Richtkopplers hervorgerufen werden. Fehlregelungen, die auf den Einfluß von externen Störsignalen zurückgehen, die beispiels-weise infolge von Mehrfachreflexionen in der Antennenleitung und/oder durch unzureichende Entkopplung der beiden Richtkoppler-Ausgänge über den Vorlaufzweig des Richtkopplers in den Regelkreis gelangen, können mit einer solchen Frequenzselektionseinrichtung jedoch nicht verhindert werden.

Die Aufgabe der Erfindung besteht darin, mit möglichst geringem Aufwand eine solche Leistungsregelanordnung so zu verbessern, daß auch über den Vorlaufzweig des Richtkopplers keine externen Störsignale in den Regelkreis gelangen können und dort Fehlregelungen verursachen.

Die erfindungsgemäße Lösung ist durch die kennzeichnendnen Merkmale des Patentanspruchs wiedergegeben.

Die Erfindung setzt zur Überwachung der auf der Antennenzuleitung vor- und rücklaufenden Wellen der Sendefrequenz eine an sich aus der DE 33 17 358 A1 für die Einstellung eines Anpaßgeräts bekannte Reflekometeranordnung ein. Wesentlich ist, daß der dem Einseitenbandgenerator zugeführte Sendesignalanteil vor der Leistungsendstufe abgezweigt wird, während die aus der DE 33 17 358 Al bekannte Reflektometeranordnung für die Einstellung eines Impedanzanpaßgerät beim Anpaßgerät in der Nähe der Antenne angeordnet ist und alle Signale aus der Antennenzuleitung bezieht. Die Rückkoppleranordnung ist bei der Leistungsregelanordnung im Sendegerät oder unmittelbar danach am Ausgang der Leistungsendstufe angeordnet.

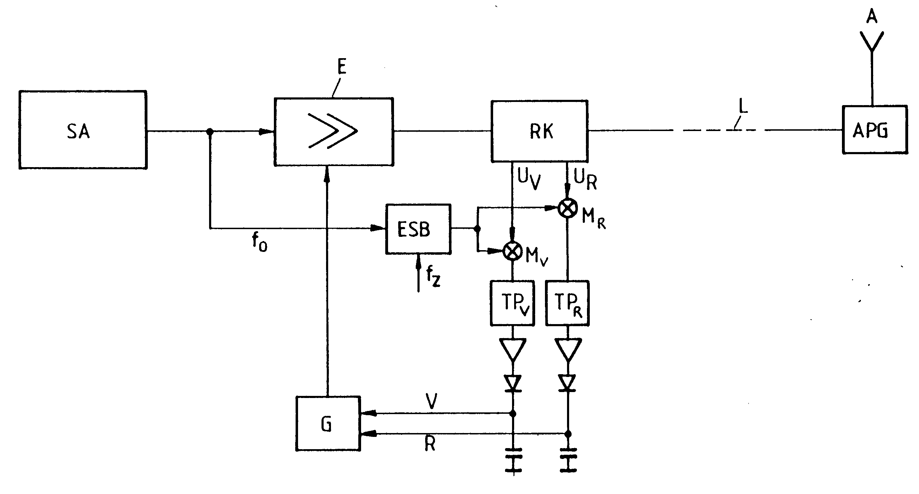

Bei der in der Abbildung skizzierten Senderanordnung wird in einer Sendesignalaufbereitungseinrichtung SA ein Sendesignal nach Frequenz und Modulation erzeugt und der Senderleistungsendstufe E zugeführt.

Das von der Endstufe verstärkte Sendesignal gelangt über einen Richtkoppler RK, die Antennenzuleitung L und ein Impedanzanpaßgerät APG zur Antenne A. In der Regel wird ein Teil der Antenne zugeführten Sendeleistung wegen nicht perfekter Impedanzanpassung reflektiert und läuft über das Anpaßgerät, die Antennenzuleitung und den Richtkoppler zurück zur Leistungsendstufe E. Der Richtkoppler RK koppelt aus der Antennenzuleitung Spannungen U_{V} und U_{R}, die den von der Endstufe zur Antenne bzw. umgekehrt laufenden Wellen proportional sind, aus. Während die vorlaufenden Wellen durch die von der Leistungsendstufe abgegebene Sendeleistung gebildet sind, setzen sich die rücklaufenden Wellen aus den an der Antenne reflektierten Anteilen und aus über die Antenne aufgenommenen Fremdsignalen zusammen, so daß die Spannung U_{V} proportional der Ausgangsleistung der Endstufe und die Spannung U_{R} proportional der Summe von reflektierter Leistung und Empfangsleistung von Fremdsignalen ist.

Vor der Endstufe wird aus dem von der Sendesignalaufbereitung bereitgestellten und der Endstufe E zugeführten Sendesignal der (variablen) Sendefrequenz fₒ ein Signalanteil abgezweigt und einem Einseitenbandgenerator ESB zugeleitet. Dem Einseitenbandgenerator ist außerdem ein Niederfrequenzsignal der konstanten Frequenz f_{z} zugeleitet. Der Einseitenbandgenerator gibt an seinem Ausgang ein Einseitenbandsignal der Frequenz fₒ + f_{z} oder fₒ - f_{z} ab. In Mischern M_{V} und M_{R} werden die Spannungen U_{V} und U_{R} mit dem Einseitenbandsignal frequenzumgesetzt und aus den Mischerausgangssignalen werden mittels Tiefpaßfiltern TP_{V} und TP_{R} die niederfrequenten Anteile bei der Frequenz f_{z} ausgefiltert, verstärkt und in amplituden-proportionale Gleichspannungen V und R umgeformt. Fremdsignale mit einem Frequenzabstand zur Sendefrequenz fₒ, der wesentlich größer ist als die Niederfrequenz f_{z} führen in den Mischerausgangsspannungen zu Mischprodukten bei deutlich höherer Frequenz als f_{z} und können durch die Tiefpaßfilter TPᵥ und TP_{R} leicht unterdrückt werden. Die Vorlauf- und Rücklaufsignale V und R sind dann allein den Amplituden der vor- und rücklaufenden Wellen bei der Sendefrequenz fₒ proportional und nicht durch Fremdeinstrahlungen verfälscht.

Ein Regelsignalgenerator G leitet aus den Signalen V und R ein Regelsignal T für die Einstellung des Verstärkungsgrads der Leistungsendstufe E ab. Fremdsignale auf der Antennenzuleitung führen nicht zu einer Reaktion des Regelkreises.

## Patentansprüche

1. Leistungsregelanordnung für Leistungsendstufen frequenzvariabler Sender, bei welcher über eine Richtkoppelanordnung (RK) den Amplituden der auf der Antennenzuleitung (L) vorlaufenden und rücklaufenden Wellen proportionale Vorlauf- und Rücklaufsignale (U_{V}, U_{R}) gewonnen und zur Ableitung einer Stellgröße zur Regelung der Verstärkung der Leistungsendstufe (E) herangezogen werden, wobei als Richtkoppelanordnung eine an sich bekannte Reflektometeranordnung (RK) eingesetzt ist, bei welcher das aus der Antennenleitung (L) ausgekoppelte Rücklaufsignal (U_{R}) in einer ersten Mischstufe (M_{R}) mit einem Referenzsignal gemischt ist, dessen Frequenz sich um eine konstante Niederfrequenz (f_{z}) von der Sendesignalfrequenz (fₒ) unterscheidet und das im Sender vor dessen Leistungsendstufe (E) erzeugt ist, wobei die in einem der ersten Mischstufe (M_{R}) nachgeschalteten ersten Tiefpaßfilter (TP_{R}) gefilterten niederfrequenten Anteile im Ausgangssignal der ersten Mischstufe (M_{R}) zur Ableitung der Stellgröße herangezogen werden, dadurch gekennzeichnet, daß das Referenzsignal ein in einem Einseitenbandgenerator (ESB) aus einem vor der Leistungsendstufe (E) abgezweigten Sendesignalanteil (fₒ) und dem Niederfrequenzsignal (f_{z}) erzeugtes Einseitenbandsignal ist und daß zusätzlich das aus der Antennenleitung (L) ausgekoppelte Vorlaufsignal (V_{V}) in einer zweiten Mischstufe (M_{V}) mit dem Referenzsignal gemischt ist und die in einem der zweiten Mischstufe (M_{V}) nachgeschalteten zweiten Tiefpaßfilter (TP_{V}) gefilterten niederfrequenten Anteile im Ausgangssignal der zweiten Mischstufe (M_{V}) zur Ableitung der Stellgröße herangezogen werden.

## Claims

1. Power regulating arrangement for power end stages of frequency-variable transmitters, in which the amplitudes of the forward and return signals (U_{V}, U_{R}) proportional to the forward-running and return-running waves on the transmission line (L) are obtained by way of a directional coupling arrangement (RK) and are utilised for the derivation of a setting magnitude for the regulation of the amplification of the power end stage (E), wherein a reflectometer arrangement (RK) known in itself is used as directional coupler arrangement, in which the return signal (U_{R}), coupled out of the transmission line. (L) is mixed in a first mixer stage (M_{R}) with a reference signal, the frequency of which differs from the transmitter signal frequency (fₒ) by a constant low-frequency (f_{z}) and which is generated in the transmitter upstream of the power end stage (E) thereof, wherein the low-frequency components, which are filtered in a first low-pass filter (TP_{R}) connected downstream of the first mixer stage (M_{R}), in the output signal of the first mixer stage (M_{R}) are drawn upon for derivation of the setting magnitude, characterised thereby that the reference signal is a single-side-band signal produced in a single-side-band generator (ESB) from a transmitter signal component (fₒ) branched off upstream of the power end stage (E) and the low-frequency signal and that in addition the forward signal (V_{V}) coupled out of the transmission line (L) is mixed in a second mixer stage (M_{V}) with the reference signal and the low-frequency components, which are filtered in a second low-pass filter (TP_{V}) connected downstream of the second mixer stage (M_{V}), in the output signal of the second mixer stage (M_{V}) are drawn upon for the derivation of the setting magnitude.

## Revendications

1. Dispositif de régulation de puissance pour étages de sortie d'émetteurs à fréquences variables avec lequel on obtient, au moyen d'un dispositif de couplage directif (RK), des signaux aller et retour (U_{V}, U_{R}) proportionnels aux amplitudes des ondes directes et récurrentes sur la conduite d'amenée d'antenne (L) et qui est utilisé pour la dérivation d'une variable réglante pour la régulation de l'amplification des étages de sortie de puissance (E), un dispositif réflectométrique (RK) connu étant utilisé comme dispositif de couplage directif, avec lequel le signal retour (U_{R}), découplé de la conduite d'antenne (L), est mélangé dans un premier étage de mélange (M_{R}) avec un signal de référence dont la fréquence diffère d'une basse fréquence (f_{z}) constante de la fréquence du signal d'émission (fₒ) et qui est généré dans l'émetteur en amont de son étage de sortie de puissance (E), des fractions à fréquence basse, filtrées dans un premier filtre passe-bas (TP_{R}) monté en aval du premier étage de mélange (M_{R}), dans le signal de sortie du premier étage de mélange (M_{R}) étant utilisées pour la dérivation de la variable réglante, **caractérisé en ce que** le signal de référence est un signal à bande latérale unique généré dans un générateur de bandes latérales uniques (ESB) à partir d'une fraction de signal d'émission (fₒ) déviée devant l'étage de sortie de puissance (E) et du signal à basse fréquence (f₂) et que en outre le signal aller découplé (V_{V}) de la conduite d'antenne (L) est mélangé avec le signal de référence dans un deuxième étage de mélange (M_{V}) et les fractions à fréquences basses, filtrées dans un deuxième filtre passe-bas (TP_{V}) monté en aval du deuxième étage de mélange (M_{V}), sont utilisées dans le signal de sortie du deuxième étage de mélange (M_{V}) pour la dérivation de la variable réglante.
